# DEMANDE DE BREVET EUROPEEN

(11) **EP 3 435 505 A1**
(43) Date de publication de la demande: **30.01.2019**
(21) Numéro de dépôt: 18182574.6
(22) Date de dépôt: 10.07.2018
(51) Int. Cl.: H02H 9/02, G06F 1/26

(54) **PROCÉDÉ DE CONTRÔLE DE COURANTS D'ENCLENCHEMENT SUSCEPTIBLES DE CIRCULER DANS UN COMMUTATEUR DE CHARGE, ET CIRCUIT ÉLECTRONIQUE CORRESPONDANT**

(30) Priorité: 24.07.2017 FR 1756995
(71) Demandeur: STMicroelectronics (ALPS) SAS, 38000 Grenoble (FR)
(72) Inventeur: LEBON, Frédéric, 38100 GRENOBLE (FR); CHEVALIER, Laurent, 38650 ROISSARD (FR)
(74) Mandataire: Casalonga

(57) **Abrégé**

Le procédé de contrôle de courants d'enclenchement susceptibles de circuler à travers un commutateur (3) couplé entre une borne d'entrée (BE) susceptible de recevoir une première tension (V_{IN}) et une borne de sortie (BS) couplée à un condensateur de découplage (4) et à une charge (5), le procédé comprenant :
une comparaison entre une première tension (V_{IN}) et une deuxième tension (V_{OUT}) présente à la borne de sortie (BS), et
une activation, en fonction du résultat de la comparaison, d'un premier (ER1) ou d'un deuxième étage de réglage (ER2) configurés pour respectivement limiter un courant d'enclenchement positif (CE+) circulant entre la borne d'entrée (BE) et la borne de sortie (BS) ou un courant d'enclenchement négatif (CE-) circulant entre la borne de sortie (BS) et la borne d'entrée (BE).

## Description

Des modes de mise en oeuvre et de réalisation de l'invention concernent les circuits électroniques, notamment les circuits électroniques comprenant au moins un commutateur couplé entre une source d'alimentation et une charge (dénommé ci-après « commutateur de charge »), plus particulièrement le contrôle de courants d'enclenchement (« Inrush current » en anglais) susceptibles de circuler dans le commutateur lorsqu'une source d'alimentation est connectée au ou déconnectée du commutateur.

D'une façon générale, un commutateur de charge classique comporte souvent un transistor MOS de commutation de type P ayant une faible tension de seuil. Afin d'obtenir une plus faible résistance à l'état passant dudit transistor, la dimension de ce transistor MOS de type P est généralement plus grande par rapport à d'autres transistors dans le même circuit électronique.

Par ailleurs, un condensateur de découplage (« bypass capacitor » en anglais) est communément utilisé pour être couplé en parallèle à ladite charge.

Ce commutateur de charge peut être connecté ou non connecté à une source d'alimentation.

Lorsque la source d'alimentation est initialement allumée, que le commutateur de charge est dans l'état passant et que le condensateur de découplage n'est pas chargé, un courant d'enclenchement (« Inrush current » en anglais) positif, circulant de la source d'alimentation vers le condensateur de découplage, apparaît au début de la charge du condensateur. L'amplitude typique de ce courant d'enclenchement positif peut atteindre quelques ampères.

De surcroît, lorsque le condensateur est chargé et que la source d'alimentation est mise à zéro de façon plus ou moins rapide, un courant d'enclenchement négatif, circulant du condensateur de découplage vers la source d'alimentation, apparaît au début de la décharge du condensateur. L'amplitude typique de ce courant d'enclenchement négatif peut atteindre des centaines de milliampères.

Ces courants d'enclenchements positifs et négatifs sont dangereux pour le fonctionnement car ils sont excessivement supérieurs au courant nominal pour lequel le circuit a été dimensionné.

Une solution classique prévoit un contrôle d'un premier courant d'enclenchement positif. Cependant, une telle solution ne peut pas limiter un éventuel courant d'enclenchement négatif et suivre une nouvelle variation de la tension de la source d'alimentation associée.

Une autre solution classique prévoit l'utilisation d'une source de courant précise, par exemple basée sur le principe de la bande interdite (« bandgap » en anglais). Néanmoins, une telle solution augmente non seulement la complexité du circuit électronique mais aussi sa consommation énergétique.

Il existe ainsi un besoin de proposer une solution technique à faible complexité et à faible consommation énergétique permettant de limiter à la fois des courants d'enclenchement positif et négatif susceptibles de circuler à travers un commutateur de charge.

Selon un aspect, il est proposé un procédé de contrôle de courants d'enclenchement susceptibles de circuler à travers un commutateur couplé entre une borne d'entrée susceptible de recevoir une première tension et une borne de sortie couplée à un condensateur de découplage et à une charge. Le procédé comprend :
une comparaison entre la première tension et une deuxième tension présente à la borne de sortie, et
une activation, en fonction du résultat de la comparaison, d'un premier ou d'un deuxième étage de réglage configurés pour respectivement limiter un courant d'enclenchement positif circulant entre la borne d'entrée et la borne de sortie ou un courant d'enclenchement négatif circulant entre la borne de sortie et la borne d'entrée.

Selon un mode de mise en oeuvre, si la première tension est plus élevée que la deuxième tension, le premier étage de réglage est activé de façon à limiter le courant d'enclenchement positif, et si la deuxième tension est plus élevée que la première tension, le deuxième étage de réglage est activé de façon à limiter le courant d'enclenchement négatif.

Un tel procédé permet avantageusement de déterminer tout d'abord le sens d'un courant d'enclenchement, à savoir positif ou négatif, et puis d'activer sélectivement un étage de réglage dédié à ce courant d'enclenchement afin de le limiter proprement.

Selon un autre aspect, il est proposé un circuit électronique comprenant
un commutateur couplé entre une borne d'entrée destinée à recevoir une première tension et une borne de sortie couplée à un condensateur de découplage et destiné à être également couplée à une charge,
un étage de comparaison configuré pour comparer la première tension et une deuxième tension présente à la borne de sortie,
un circuit de contrôle configuré pour activer, en fonction du résultat de la comparaison entre, un premier ou un deuxième étage de réglage respectivement configuré pour limiter un courant d'enclenchement positif ou un courant d'enclenchement négatif.

Selon un mode de réalisation, si la première tension est supérieure à la deuxième tension, le circuit de contrôle est configuré pour activer le premier étage de réglage de façon à limiter le courant d'enclenchement positif, et
si la deuxième tension est supérieure à la première tension, le circuit de contrôle est configuré pour activer le deuxième étage de réglage de façon à limiter le courant d'enclenchement négatif.

Le commutateur peut par exemple comporter un transistor de commutation et le premier étage de réglage peut par exemple comprendre
un premier condensateur de détection configuré pour transformer une variation positive de la deuxième tension en une variation d'un premier courant intermédiaire via un premier module de miroir de courant,
un premier module de courant de référence configuré pour générer un premier courant de référence, et
un premier module de réglage de tension configuré pour augmenter la tension de la grille du transistor de commutation si le premier courant intermédiaire est supérieur au premier courant de référence.

Le commutateur peut par exemple comporter un transistor de commutation et le deuxième étage de réglage peut par exemple comprendre
un deuxième condensateur de détection configuré pour transformer une variation négative de la deuxième tension en une variation d'un deuxième courant intermédiaire via un deuxième module de miroir de courant,
un deuxième module de courant de référence configuré pour générer un deuxième courant de référence, et
un deuxième module de réglage de tension configuré pour augmenter la tension de la grille du transistor de commutation si le deuxième courant intermédiaire est supérieur au deuxième courant de référence.

Selon un mode de réalisation, le transistor de commutation est du type PMOS.

Selon un autre mode de réalisation, les premier et deuxième modules de réglage de tension comportent respectivement un transistor du type PMOS dont la source est couplée à la plus grande des première et deuxième tensions et le drain est couplé à la grille du transistor de commutation.

Selon encore un autre mode de réalisation, les premier et deuxième modules de courant de référence sont sensiblement identiques,
les premier et deuxième courants de référence sont sensiblement identiques, et
les premier et deuxième modules de réglage de tension sont sensiblement identiques.

Avantageusement, le circuit peut par exemple être réalisé de façon intégrée.

Selon un autre aspect, il est proposé un système électronique, notamment alimenté par au moins une batterie, comportant au moins un circuit tel que défini ci-avant.

Selon encore un autre aspect, il est proposé un appareil électronique, tel que téléphone portable cellulaire, tablette, ou ordinateur portable, comprenant au moins un système tel que défini ci-dessus.

D'autres avantages et caractéristiques de l'invention apparaîtront à l'examen de la description détaillée de modes de mise en oeuvre et de réalisation, nullement limitatifs, et des dessins annexés sur lesquels :

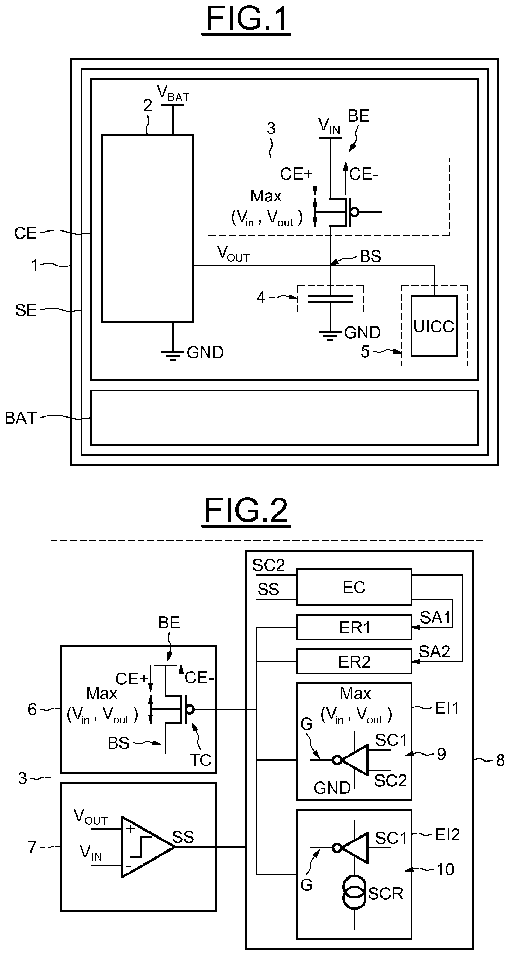

- les figures 1 à 4 illustrent schématiquement des modes de mise en oeuvre et de réalisation de l'invention.

La référence 1 sur la figure 1 désigne un appareil électronique, ici par exemple un téléphone portable cellulaire alimenté par une batterie BAT.

Le téléphone portable 1 comporte un système électronique SE réalisé de façon intégrée. Le système électronique SE comprend en outre un circuit électronique CE comprenant
un régulateur de tension à faible chute 2, de structure classique communément connu par l'homme du métier sous l'acronyme anglo-saxon « LDO » (« Low-DropOut voltage regulator » : en anglais), couplé entre la tension V_{BAT} de la batterie et la masse GND et fournissant à une borne de sortie BS une tension de sortie V_{OUT},
un circuit de commutateur de charge 3 couplé entre une borne d'entrée BE et la borne de sortie BS du régulateur de tension à faible chute 2,
un condensateur de découplage 4 couplé entre la borne de sortie BS et la masse GND, et
un circuit de charge 5, ici par exemple une carte de circuit intégré universelle, communément connu par l'homme du métier sous l'acronyme anglo-saxon « UICC » (« Universal Integrated Circuit Card » : en anglais).

A titre d'exemple non limitatif, la borne d'entrée BS peut être couplée à un rail d'alimentation fourni par le système électronique SE et étant différent de celui de la tension de batterie V_{BAT}. La borne d'entrée BE peut par exemple recevoir une tension d'entrée V_{IN} dont la valeur est supérieure à zéro et inférieure ou égale à la tension V_{BAT} de la batterie. La tension VIN peut être fournie par une source d'alimentation, un régulateur à faible chute de tension par exemple.

Le téléphone portable 1 peut fonctionner sous plusieurs modes dont un mode normal et un mode de veille.

Lorsque le téléphone 1 fonctionne sous le mode normal, le régulateur de tension 2 est alimenté par la tension V_{BAT} et délivre à la borne de sortie BS la tension de sortie V_{OUT}. Le circuit de commutateur de charge 3 est dans l'état bloqué et par conséquent le circuit de charge 5 et le condensateur de découplage 4 sont alimentés par la tension de sortie V_{OUT}.

Lorsque le téléphone 1 fonctionne dans le mode de veille, le régulateur de tension 2 est déconnecté et le circuit commutateur de charge 3 est dans l'état passant. Le condensateur de découplage 4 et le circuit de charge 5 sont donc alimentés par la tension d'entrée V_{IN} de façon à améliorer l'efficacité énergétique du système SE.

Si la tension d'entrée V_{IN} est déjà établie lorsque le circuit de commutateur 3 devient passant, la tension V_{OUT} présente à la borne de sortie BS est inférieure à la tension d'entrée V_{IN} présente à la borne d'entrée BE.

La variation rapide positive de la tension appliquée Δ(V_{IN}-V_{OUT}) sur le circuit de commutateur de charge 3 conduit à un courant d'enclenchement positif CE+ circulant de la borne d'entrée BE vers la borne de sortie BS de façon à charger le condensateur de découplage 4.

Lorsque le condensateur de découplage 4 est chargé et que la tension de d'entrée V_{IN} est mise à zéro de façon plus ou moins rapide, la variation rapide négative de la tension appliquée Δ(V_{IN}-V_{OUT}) sur le circuit de commutateur de charge 3 conduit à un courant d'enclenchement négatif CE- circulant de la borne sortie BS vers la borne d'entrée BE de façon à décharger le condensateur de découplage 4.

Il est donc prévu un circuit de contrôle destiné à limiter ces courants d'enclenchements, et qui va être décrit plus en détails ci-après.

On se réfère maintenant à la figure 2 pour illustrer très schématiquement un exemple du circuit de commutateur de charge 3.

Le circuit de commutateur de charge 3 comporte
un commutateur de charge 6 (« charge switch » en anglais) comprenant un transistor MOS de commutation TC de type P dont la source est couplée à la borne d'entrée BE, dont le drain est couplé à la borne de sortie BS, dont le substrat est couplé à la plus grande des tensions d'entrée V_{IN} et de sortie V_{OUT},
un étage de comparaison 7 configuré pour comparer les tensions d'entrée V_{IN} et de sortie V_{OUT}, et pour délivrer un signal de sélection SS en fonction du résultat de la comparaison, et
un circuit de contrôle 8 couplé à la grille G du transistor de commutation TC et comportant un premier et un deuxième étages de réglage ER1 et ER2.

Le circuit de contrôle 8 est configuré pour activer en fonction du signal de sélection SS, le premier ou le deuxième étage de réglage ER1 ou ER2. Chaque étage de réglage ER1 ou ER2 est configuré pour régler la tension de la grille du commutateur 6 de façon à limiter respectivement le courant d'enclenchement positif CE+ ou le courant d'enclenchement négatif CE-.

A titre d'exemple, le circuit de contrôle 8 peut comprendre en outre
un étage de contrôle EC configuré pour activer sélectivement le premier ou le deuxième étage de réglage ER1 ou ER2,
un premier étage inverseur EI1 dont la sortie est couplée à la grille G du transistor de commutation TC, et
un deuxième étage inverseur EI2 dont la sortie est également couplée à la grille G du transistor de commutation TC.

Le premier étage inverseur EI1 comporte ici par exemple un inverseur de tension à trois états 9 alimenté par la plus grande des tensions d'entrée V_{IN} et de sortie V_{OUT} et la masse GND. La structure d'un inverseur de tension 9 est connue en soi de l'homme du métier. Cet inverseur 9 reçoit
à sa première entrée un premier signal de contrôle SC1 pour inverser à sa sortie sur la grille du commutateur, et
à sa deuxième entrée un deuxième signal de contrôle SC2 pour autoriser le fonctionnement de l'inverseur de tension à trois états 9.

Lorsque le deuxième signal de contrôle SC2 est dans l'état bas, le premier signal de contrôle SC1 est inversé sur la grille G du transistor de commutation TC. Dans le cas contraire, c'est-à-dire lorsque le deuxième signal de contrôle SC2 est dans l'état haut, l'inverseur de tension 9 est dans un état d'impédance élevée.

Il convient de noter que le premier étage inverseur EI1 n'est pas indispensable pour le circuit de commutateur de charge 3 et que si le deuxième signal de contrôle SC2 est dans l'état bas, la tension d'entrée V_{IN} du commutateur 3 est censée être traitée en amont de façon à limiter une variation rapide pouvant conduire à des courants d'enclenchement positif ou négatif CE+, CE-.

Lorsque le premier étage inverseur EI1 est en fonctionnement, le deuxième étage inverseur EI2, les premier et deuxième étages de réglages ER1 et ER2, et l'étage comparateur 7 sont tous configurés pour être désactivés.

Le deuxième étage inverseur EI2 comporte ici par exemple un inverseur de tension dit « appauvri » 10 (« starved inverter » en anglais) ayant un courant limité. Cet amplificateur 10 est alimenté entre la plus grande des tensions d'entrée V_{IN} et de sortie V_{OUT} et la masse GND à travers une source de courant de référence SCR lorsque le deuxième signal de contrôle SC2 est dans l'état haut.

Le deuxième étage inverseur EI2 reçoit à son entrée le premier signal de contrôle SC1 et délivre à sa sortie la tension de grille V_{G} du transistor de commutation TC.

La source de courant de référence SCR peut être une simple source de courant, par exemple comportant un miroir de courant générant un courant proportionnel à la température absolue. Cette source de courant peut par exemple également être utilisée dans les premier et deuxième étages de réglage ER1 et ER2 qui seront détaillés ci-après.

Il convient de noter que la source de courant de référence SCR est destinée à limiter la force de l'inverseur de tension 10 lorsque l'inverseur 10 tire la tension de grille V_{G} du transistor de commutation TC vers le bas de façon à permettre au premier ou au deuxième étage de réglage ER1 et ER2 de tirer la tension de grille V_{G} vers le haut.

L'étage comparateur 7 reçoit à son entrée positive la tension d'entrée V_{IN} et à son entrée négative la tension de sortie V_{OUT}, et délivre à sa sortie le signal de sélection SS.

Lorsque la tension d'entrée V_{IN} est supérieure à la tension de sortie V_{OUT}, le signal de sélection SS est par exemple dans l'état bas.

Dans le cas contraire, la tension d'entrée V_{IN} est inférieure à la tension de sortie V_{OUT}, et le signal de sélection SS est dans l'état haut.

L'étage de contrôle EC est destiné à recevoir le deuxième signal de contrôle SC2 et le signal de sélection SS, et configuré pour délivrer respectivement aux premier et deuxième étages de réglage ER1, ER2, un premier signal d'activation SA1 et un deuxième signal d'activation SA2 en fonction des signaux de contrôle SC2 et de sélection SS.L'étage de contrôle EC peut par exemple être réalisé avec un circuit logique classique.

Le premier signal d'activation SA1 est dans l'état haut lorsque le deuxième signal de contrôle SC2 est dans l'état haut et le signal de sélection SS est dans l'état bas. Dans ce cas là, le premier étage de réglage ER1 est activé.

Le deuxième signal d'activation SA2 est dans l'état haut lorsque le deuxième signal de contrôle SC2 est dans l'état haut et le signal de sélection SS est dans l'état haut. Dans ce cas là, le deuxième étage de réglage ER2 est activé.

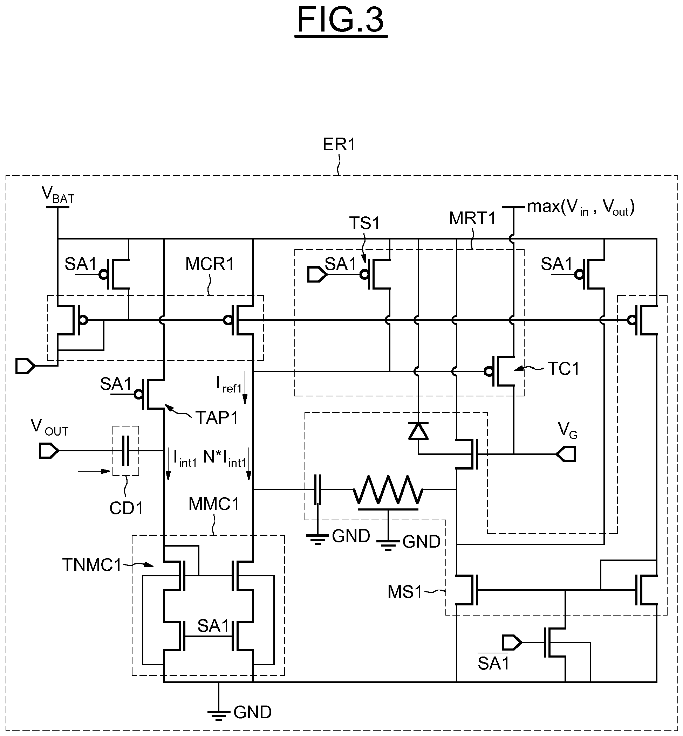

On se réfère maintenant à la figure 3 pour illustrer schématiquement un exemple de réalisation du premier étage de réglage ER1.

Le premier étage de réglage ER1 comprend
un premier condensateur de détection CD1 couplé à la tension de sortie V_{OUT} et configuré pour transformer une variation positive de la tension de sortie V_{OUT} en une variation d'un premier courant interne Iᵢₙₜ₁,
un premier module de miroir de courant MMC1 comportant ici par exemple un premier miroir de courant de type NMOS connu en soi et ayant un taux de transfert en courant égal à N,
un premier module de courant de référence MCR1 configuré pour générer un premier courant de référence I_{ref1}, et
un premier module de réglage de tension MRT1 comportant
un premier transistor TC1 du type PMOS dont la grille est couplée à la sortie du premier module de courant de référence MCR1 et à la sortie du premier module de miroir de courant MMC1, et dont la source est couplée à la plus grande des tensions d'entrée V_{IN} et de sortie V_{OUT} et dont le drain est couplé à la grille du commutateur 6.

Le premier module de miroir de courant MMC1 comporte un premier transistor NMOS de miroir de courant TNMC1 monté en diode dont le drain est couplé à la tension de batterie V_{BAT} via un premier transistor auxiliaire TAPI du type PMOS.

Le transistor TAPI reçoit à sa grille le premier signal d'activation SA1. Lorsque le premier signal d'activation SA1 est dans l'état bas, le transistor TAPI est dans son état passant. Le transistor TNMC1 est ainsi polarisé par la tension de batterie V_{BAT}. Il convient de noter que la référence SA1 illustrée sur la figure 3 est un signal complémentaire du premier signal d'activation SA1.

Lorsque le premier signal d'activation SA1 est dans l'état haut, le transistor TAP1 est dans son état bloqué. La variation positive de la tension V_{OUT} est transformée en la variation du premier courant interne Iᵢₙₜ₁ via le premier condensateur de détection CD1.

Le premier module de miroir de courant MMC1 est en fonctionnement grâce à la polarisation du transistor TNMC1 via le transistor TAP1 lorsque le premier signal d'activation SA1 est dans l'état bas.

Cette structure dynamique permet avantageusement une activation du premier étage de réglage ER1 seulement lorsque le premier signal d'activation SA1 est dans l'état haut.

Le premier module de miroir de courant MMC1 est configuré pour générer à partir du premier courant interne Iᵢₙₜ₁ un premier courant intermédiaire N*Iᵢₙₜ₁.

Si le premier courant intermédiaire N*Iᵢₙₜ₁ devient supérieur au premier courant de référence I_{ref1}, la tension de la grille du premier transistor TC1 diminue et la tension de la grille V_{G} du transistor de commutation TC est donc tirée vers le haut.

Le premier étage de réglage ER1 comprend en outre un premier module de stabilisation MS1 connu en soi de l'homme du métier et configuré pour stabiliser le premier étage de réglage ER1.

Ainsi, la tension grille source du transistor de commutation TC est diminuée de façon à réduire le courant d'enclenchement positif CE+ circulant de la borne d'entrée BE vers la borne sortie BS.

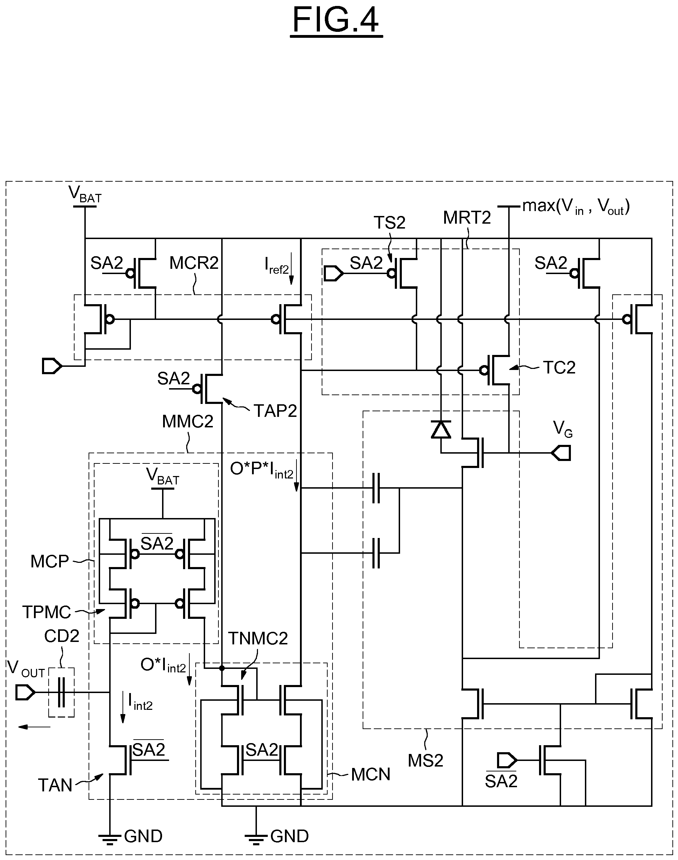

Par analogie, on se réfère maintenant à la figure 4 pour illustrer schématiquement un exemple de réalisation du deuxième étage de réglage ER2.

Le deuxième étage de réglage ER2 comprend
un deuxième condensateur de détection CD2 couplé à la tension de sortie V_{OUT} et configuré pour transformer une variation négative de la tension de sortie V_{OUT} en une variation d'un deuxième courant interne Iᵢₙₜ₂,
un deuxième module de miroir de courant MMC2 comportant ici par exemple un deuxième miroir de courant MCP du type PMOS et un deuxième miroir de courant MCN du type NMOS connus en soi et ayant respectivement des taux de transfert en courant égaux à O et P,
un deuxième module de courant de référence MCR2 configuré pour générer le deuxième courant de référence I_{ref2}, et
un deuxième module de réglage de tension MRT2 comportant
un deuxième transistor TC2 du type PMOS dont la grille est couplée à la sortie du deuxième module de courant de référence MCR2 et à la sortie du deuxième module de miroir de courant MMC2, et dont la source est couplée à la plus grande des tensions d'entrée V_{IN} et de sortie V_{OUT} et dont le drain est couplé à la grille G du transistor de commutation TC.

A titre indicatif, le circuit de commutateur de charge 3 peut recevoir un courant de référence, par exemple un courant proportionnel à la température absolue (« proportional to absolute temperature current » en anglais), qui est recopié pour créer les courants de la source de courant de référence SCR, du premier module de courant de source MCR1 et du deuxième module de courant de référence MCR2.

Le deuxième miroir de courant MCP du type PMOS comporte un transistor PMOS de miroir de courant TPMC monté en diode dont le drain est couplé à la masse GND via un transistor auxiliaire TAN du type NMOS.

Le transistor TAN reçoit à sa grille un signal complémentaire S̅A̅2̅ du deuxième signal d'activation SA2. Lorsque le deuxième signal d'activation SA2 est dans l'état bas, le signal complémentaire S̅A̅2̅ est dans l'état haut. Le transistor TAN est par conséquent dans son état passant. Le transistor TPMC est ainsi polarisé via la masse GND.

Lorsque le deuxième signal d'activation SA2 est dans l'état haut, le signal complémentaire S̅A̅2̅ est dans l'état bas. Le transistor TAN est dans son état bloqué. La variation négative de la tension V_{OUT} est transformée en la variation du deuxième courant interne Iᵢₙₜ₂ via le deuxième condensateur de détection CD2.

Le deuxième miroir de courant MCN du type NMOS comporte un deuxième transistor NMOS de miroir de courant TNMC2 monté en diode dont le drain est couplé à la tension de batterie V_{BAT} via un deuxième transistor auxiliaire TAP2 du type PMOS.

Tout comme décrit ci-avant pour le premier transistor NMOS de miroir de courant TNMC1 et le premier transistor auxiliaire TAPI, le transistor TAP2 est configuré pour être dans l'état passant lorsque le deuxième signal d'activation SA2 est dans l'état bas de façon à permettre au transistor TNMC2 d'être polarisé par la tension de batterie V_{BAT}.

Le deuxième module de miroir de courant MMC2 est par conséquent en fonctionnement grâce aux polarisations du transistor TPMC via le transistor TAN et du transistor TNMC2 via le transistor TAP2 lorsque le deuxième signal d'activation SA2 est dans l'état bas.

Ces structures dynamiques permettent avantageusement une activation du deuxième étage de réglage ER2 seulement lorsque le deuxième signal d'activation SA2 est dans l'état haut.

Il convient de noter que le premier ou le deuxième signal d'activation SA1 ou SA2 est positionné juste au moment où on a besoin d'activer le premier ou le deuxième étage de réglage ER1 ou ER2 car les premier et deuxième étages de réglage ER1 et ER2 comportent les structures dynamiques comme décrit ci-avant.

Le deuxième module de miroir de courant MMC2 est configuré pour générer à partir du deuxième courant interne Iᵢₙₜ₂ un deuxième courant intermédiaire O*P*Iᵢₙₜ₂. Il convient de noter que le deuxième miroir de courant MCP du type PMOS est particulièrement configuré pour générer un courant O*Iᵢₙₜ₂ dont la direction est adaptée pour la génération du deuxième courant intermédiaire O*P*Iᵢₙₜ₂ via le deuxième miroir de courant MCN du type NMOS.

Si le deuxième courant intermédiaire O*P*Iᵢₙₜ₂ devient supérieur au deuxième courant de référence I_{ref2}, la tension de la grille du deuxième transistor TC2 diminue et la tension de la grille V_{G} du transistor de commutation TC est donc tirée vers le haut.

Par ailleurs, le deuxième étage de réglage ER2 comprend un deuxième module de stabilisation MS2 connu en soi de l'homme du métier et configuré pour stabiliser le deuxième étage de réglage ER2.

Ainsi, la tension grille source du transistor de commutation TC est diminuée de façon à réduire le courant d'enclenchement négatif CE- circulant de la borne de sortie BS vers la borne d'entrée BE.

L'invention n'est pas limitée aux modes de réalisation qui viennent d'être décrits mais en embrasse toutes les variantes.

A titre d'exemple non limitatif, les premier et deuxième modules de courant de référence (MCR1, MCR2) peuvent être sensiblement identiques.

En outre, les premier et deuxième courants de référence (I_{ref1}, I_{ref2}) peuvent être sensiblement identiques, et les premier et deuxième modules de réglage de tension (MRT1, MRT2) peuvent être sensiblement identiques.

## Revendications

1. Procédé de contrôle de courants d'enclenchement susceptibles de circuler à travers un commutateur (3) couplé entre une borne d'entrée (BE) susceptible de recevoir une première tension (V_{IN}) et une borne de sortie (BS) couplée à un condensateur de découplage (4) et à une charge (5), le procédé comprenant :
une comparaison entre une première tension (V_{IN}) et une deuxième tension (V_{OUT}) présente à la borne de sortie (BS), et
une activation, en fonction du résultat de la comparaison, d'un premier (ER1) ou d'un deuxième étage de réglage (ER2) configurés pour respectivement limiter un courant d'enclenchement positif (CE+) circulant entre la borne d'entrée (BE) et la borne de sortie (BS) ou un courant d'enclenchement négatif (CE-) circulant entre la borne de sortie (BS) et la borne d'entrée (BE).

2. Procédé selon la revendication 1, dans lequel si la première tension (V_{IN}) est plus élevée que la deuxième tension (V_{OUT}), le premier étage de réglage (ER1) est activé de façon à limiter le courant d'enclenchement positif (ER2), et si la deuxième tension (V_{OUT}) est plus élevée que la première tension (V_{IN}), le deuxième étage de réglage (ER2) est activé de façon à limiter le courant d'enclenchement négatif (CE-).

3. Circuit électronique, comprenant
un commutateur (6) couplé entre une borne d'entrée (BE) destinée à recevoir une première tension et une borne de sortie (BS) couplée à un condensateur de découplage (4) et destinée à être également couplée à une charge (5),
un étage de comparaison (7) configuré pour comparer la première tension (V_{IN}) et une deuxième tension (V_{OUT}) présente à la borne de sortie (BS),
un circuit de contrôle (8) configuré pour activer, en fonction du résultat de la comparaison, un premier ou un deuxième étage de réglage (ER1, ER2) respectivement configuré pour limiter un courant d'enclenchement positif (CE+) circulant entre la borne d'entrée (BE) et la borne de sortie (BS) ou un courant d'enclenchement négatif (CE-) circulant entre la borne de sortie (BS) et la borne d'entrée (BE).

4. Circuit selon la revendication 3, dans lequel
si la première tension (V_{IN}) est supérieure à la deuxième tension (V_{OUT}), le circuit de contrôle (8) est configuré pour activer le premier étage de réglage (ER1) de façon à limiter le courant d'enclenchement positif (CE+), et
si la deuxième tension (V_{OUT}) est supérieure à la première tension (V_{IN}), le circuit de contrôle (8) est configuré pour activer le deuxième étage de réglage (ER2) de façon à limiter le courant d'enclenchement négatif (CE-).

5. Circuit selon la revendication 4, dans lequel le commutateur comporte un transistor de commutation (TC) et le premier étage de réglage (ER1) comprend
un premier condensateur de détection (CD1) configuré pour transformer une variation positive de la deuxième tension (V_{OUT}) en une variation d'un premier courant intermédiaire (N*Iᵢₙₜ₁) via un premier module de miroir de courant (MMC1),
un premier module de courant de référence (MCR1) configuré pour générer un premier courant de référence (I_{ref1}), et
un premier module de réglage de tension (MRT1) configuré pour augmenter la tension de la grille (V_{G}) du transistor de commutation (TC) si le premier courant intermédiaire (N*Iᵢₙₜ₁) est supérieur au premier courant de référence(I_{ref1}).

6. Circuit selon la revendication 4 ou 5, dans lequel le commutateur comporte un transistor de commutation (TC) et le deuxième étage de réglage (ER2) comprend
un deuxième condensateur de détection (CD2) configuré pour transformer une variation négative de la deuxième tension (V_{OUT}) en une variation d'un deuxième courant intermédiaire (O*P*Iᵢₙₜ₂) via un deuxième module de miroir de courant (MMC2),
un deuxième module de courant de référence (MCR2) configuré pour générer un deuxième courant de référence (I_{ref2}), et
un deuxième module de réglage de tension (MRT2) configuré pour augmenter la tension de la grille (V_{G}) du transistor de commutation (TC) si le deuxième courant intermédiaire (O*P*Iᵢₙₜ₂) est supérieur au deuxième courant de référence (I_{ref2}).

7. Circuit selon les revendications 5 et 6, dans lequel
les premier et deuxième modules de courant de référence (MCR1, MCR2) sont identiques,
les premier et deuxième courants de référence (I_{ref1}, I_{ref2}) sont identiques, et
les premier et deuxième modules de réglage de tension (MRT1, MRT2) sont identiques.

8. Circuit selon l'une quelconque des revendications 3 à 7, le transistor de commutation (TC) est du type PMOS.

9. Circuit selon les revendications 7 et 8, dans lequel les premier et deuxième modules de réglage de tension (MRT1, MRT2) comportent respectivement un transistor (TC1 et TC2) du type PMOS dont la source est couplée à la plus grande des première et deuxième tensions (V_{IN} et V_{OUT}) et le drain est couplé à la grille (G) du transistor de commutation (TC).

10. Circuit selon l'une quelconque des revendications 3 à 9, réalisé de façon intégré.

11. Système électronique, notamment alimenté par au moins une batterie (BAT), comportant au moins un circuit (CE) selon l'une quelconque des revendications 3 à 10.

12. Appareil électronique, tel que téléphone portable cellulaire, tablette, ou ordinateur portable, comprenant au moins un système (SE) selon la revendication 11.
